# EUROPEAN PATENT SPECIFICATION

(11) **EP 0 489 559 B1**
(45) Date of publication and mention of the grant of the patent: **12.07.1995**
(21) Application number: 91311183.7
(22) Date of filing: 02.12.1991
(51) Int. Cl.: H01L 29/772, H01L 21/336

(54) **LDD metal-oxide semiconductor field-effect transistor and method of making the same**
LDD Metalloxyd-Halbleiter-Feldeffekttransistor und Verfahren zur Herstellung
Transistor à effet de champ métal-oxyde semi-conducteur LDD et sa méthode de fabrication

(30) Priority: 30.11.1990 JP 339394/90
(43) Date of publication of application: 10.06.1992
(73) Proprietor: NEC CORPORATION, Tokyo (JP)
(72) Inventor: Okabe, Kazuhiro, c/o NEC Corporation, Tokyo 108-01 (JP); Sakai, Isami, c/o NEC Corporation, Tokyo 108-01 (JP)
(74) Representative: Abnett, Richard Charles

(56) References cited:
- EP-A- 0 187 016
- US-A- 4 746 624
- US-A- 4 771 012
- INTERNATIONAL ELECTRON DEVICES MEETING 1980 TECHNICAL DIGEST, pp. 764-767 ; W.R. HUNTER et al. : "New Edge-Defined Vertical-Etch Approaches For Submicrometer MOSFET Fabrication"
- PATENT ABSTRACTS OF JAPAN vol. 9, no. 298 (E-361)(2021) 26 November 1985 ; & JP-A-60 136 376

## Description

The present invention relates to a method of making a metal-oxide semiconductor field-effect transistor structure, and particularly to the drain structure of such a semiconductor device. Also, the present invention relates to a metal-oxide semiconductor field-effect transistor structure made by the method.

As is well known, the lightly doped drain structure of a metal-oxide semiconductor field effect transistor (abbreviated MOSFET) comprises a lightly doped section starting from a location under one edge of the gate and extending a relatively short distance apart from said location, and a heavily doped section following said lightly doped section and extending a relatively long distance apart from the gate. The presence of such lightly doped section ahead of the heavily doped section will cause the strength of the electric field appearing in the vicinity of the drain of the device to be reduced so as to suppress appearance of hot carriers. Such hot carriers are liable to invade the gate through the underlying metal oxide and to remain in the gate, and as a result the performance of the device will change with age. Adoption of the lightly doped drain structure in a MOSFET improves substantially the reliability of the device.

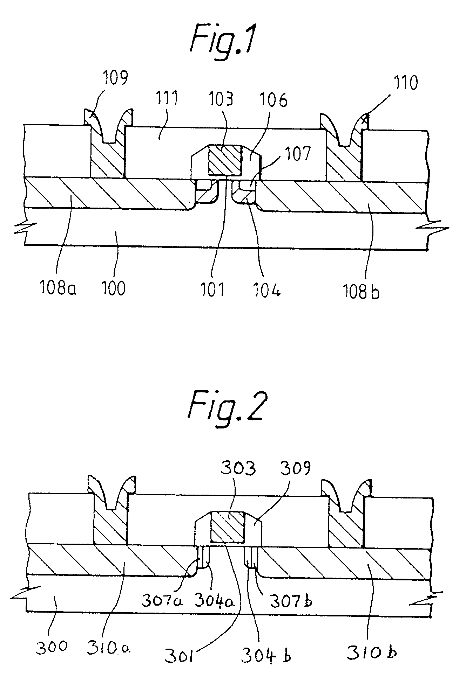

The lightly doped section, however, functions as a parasitic resistor, and disadvantageously it will lower the current driving capability of the device. In an attempt to solve this problem a profiled lightly doped drain structure (abbreviated PLDD) was proposed (See the paper "Profiled Lightly Doped Drain (PLDD) Structure for High Reliable NMOSFETs", Y. Toyoshima et al, Digest of Technical Papers, Symposium on VLSI Technology,pp.118-119, 1985). Fig. 1 shows, in section, a PLDD structure. It comprises a P-type silicon substrate 100, a gate insulating layer 101 formed on the top surface of the substrate 100, a gate 103 built on the gate insulating layer 101, an N-type source diffusion layer 108a, and an N-type drain diffusion layer 108b. The gate 103 has a surrounding wall 106, and the source and drain diffusion layers 108a and 108b have electrodes 109 and 110 respectively. These electrodes 109 and 110 are embedded in an overlying insulating layer 111. It is noted that: the drain diffusion layer is composed of an upper short projection 107 of least concentration of impurity such as arsenic, a surrounding section 104 of less concentration of impurity such as phosphorus, and an elongated section 108b of relatively high concentration of impurity such as arsenic, lying contiguous to the upper projection 107 and surrounding section 104, which end at a location under one edge of the gate 103.

The coexistence of less doped core 107 and least doped enclosure 104 prevents effectively the lowering of the current driving capability of the device.

In the PLDD structure, however, carriers are liable to come together toward the upper surface of the substrate 100, and as the device size is decreased, hot carriers will be most likely to appear in the vicinity of the upper surface of the substrate 100, invading the gate 103 through the underlying insulating layer 101 to lower the characteristics of the device. Also, further miniaturization of MOSFETs having a PLDD incorporated therein will cause the least doped enclosure 104 to function as a parasitic resistor, thereby lowering the current driving capability of the device.

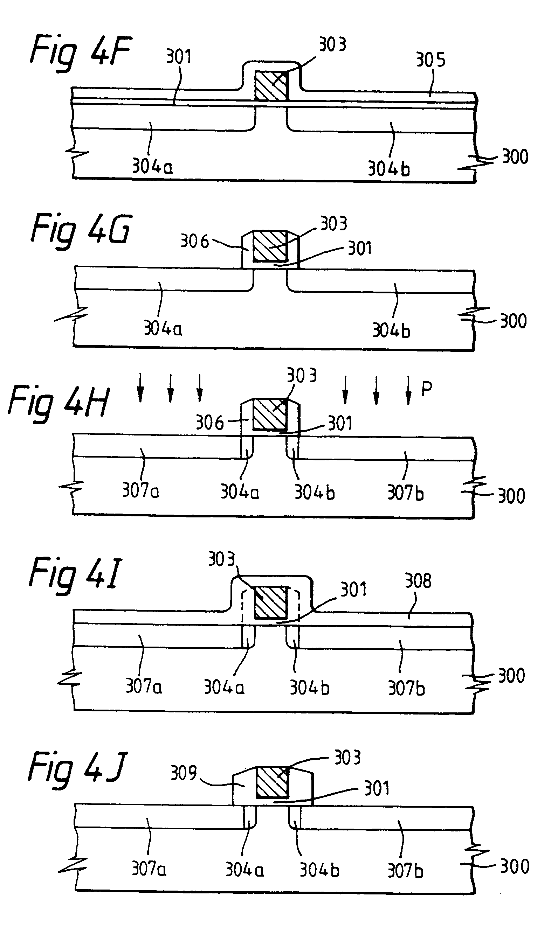

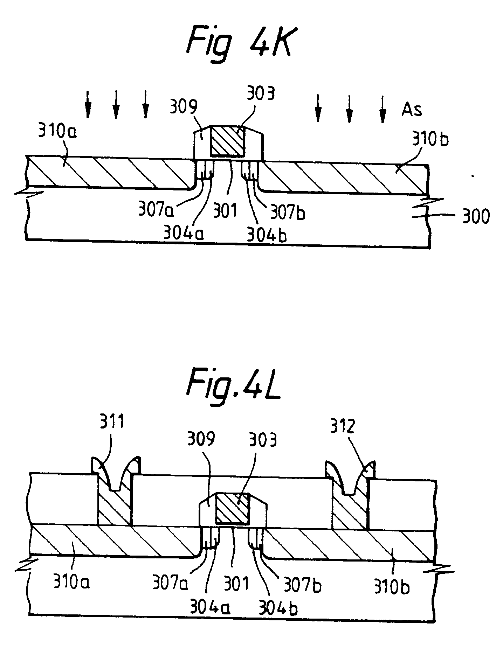

European patent application EP 0187016 describes a device of this type, at figure 4, and also describes at figures 6 to 9 a second type of MOSFET in which three regions of the LDD structure having less, least (intermediate) and highest impurity concentrations are arranged in series. This type of structure is described at figure 2 herein, where the known MOSFET is shown as comprising: a P-type silicon substrate 300; a gate insulating layer 301 of silicon formed on the top surface of the substrate 300; a gate 303 built on the gate insulation 301; an N-type source diffusion layer 304a and an N-type drain diffusion layer 304b extending toward and ending at first locations under one and the other edges of the gate 303 respectively in opposite directions in the substrate 300; and an N-type source diffusion layer 307a and an N-type drain diffusion layer 307b extending toward and ending at second locations under one and the other edges of the gate 303 respectively in opposite directions in the substrate 300. It should be noted that the source diffusion layer is composed of a first relatively short section 304a of least concentration of impurity, a second relatively short section 307a of less concentration of impurity, and a third relatively long section 310a of relatively high concentration of impurity lying contiguous to each other and extending far from the first location in the order named. The drain diffusion layer has also the same structure 304b, 307b, 310b.

The first short sections 304a and 304b of least concentration and the second short sections 307a and 307b of less concentration extend to the same depth, thereby causing carriers to travel through an increased transverse area in the semiconductor substrate 300 compared with a PLDD structure, in which carriers come together close to the top surface of the semiconductor substrate 300. Thus, the MOSFET of Figure 2 shows improved freedom from deterioration of the characteristics of the device compared with that of Figure 1. Also, advantageously the parasitic resistance is reduced two to three times, and accordingly the current driving capability is increased.

As described in EP 0187016 this structure is made by a sequence of masking and ion implantation steps. The steps involved are illustrated in Figures 4F to 4L herein. First, a semi-fabricated product comprising a P-type substrate 300 with a gate insulating layer 301 of metal oxide formed on its top surface, and a gate 303 built on the gate insulating layer 301 is prepared according to a conventional method.

Phosphorus ions (1 x 10¹³cm⁻²; 35 KeV) are injected perpendicular to the top surface of the P-type substrate 300 to form two opposite N-type diffusion layers 304a and 304b of least concentration of phosphorus in the substrate 300. These diffused regions 304a and 304b extend from first and second locations under one and the other edges of the gate 303 respectively in opposite directions.

A 1000 angstrom-thick oxide layer 305 is formed on the semi-fabricated product (Fig.4F); and the thick oxide layer 305 is subjected to anisotropic etching until the top surface of the substrate 300 is exposed to leave a side wall 306 surrounding the gate 303 (Fig.4G).

Phosphorus ions (1 x 10¹⁴cm⁻²; 35 KeV) are injected perpendicular to the P-type substrate 300 to form two opposite N-type diffusion layers 307a and 307b of less concentration of phosphorus in the substrate 300 (Fig.4H). These diffused regions 307a and 307b extend short of the terminal ends of the diffusion layers 304a and 304b of least concentration of phosphorus.

A 2000 angstrom-thick oxide layer 308 is then formed on the sidewalled product (Fig.4I); and the thick oxide layer 308 is subjected to anisotropic etching until the top surface of the substrate 300 is exposed to leave a second side wall 309 surrounding the first side wall 306 of the gate 303 (Fig.4J).

Arsenic ions (5 x 10¹⁵cm⁻²; 40 KeV) are injected perpendicular to the P-type substrate 300 to form two opposite diffusion layers 310a and 310b of relatively high concentration of arsenic in the substrate 300 (Fig.4K). These heavily diffused regions 310a and 310b extend from first and second locations under one and the other edges of the second side wall 309 in opposite directions.

Finally, a source electrode 311, a drain electrode 312 and a gate electrode (not shown) are formed respectively (Fig.4L).

In this process it should be noted that a different mask is required for forming each of the three implanted regions, provided respectively by the gate, the first side wall and the second side wall.

US patent No. 4746624 describes a MOSFET structure very similar to that of Figures 2 and 4F to 4L herein and manufactured similarly by using three separate masking steps.

Japanese patent publication No. JP-A-60136376, as set out in Patent Abstracts of Japan Vol. 9, No.298, describes a further MOSFET having a LDD structure in which the source and drain each comprise three regions of different impurity concentrations. Two regions are initially implanted, using the gate and a subsequently formed side wall as masks, and the third region formed between the first two by a diffusion process.

VLSI Technology, S.M. Sze, editor, McGraw Hill, 1988, pages 362, 363 describes a process for reducing the depth of an ion-implanted region for a given ion type and ion beam energy by tilting the ion beam direction with respect to the implanted surface. This is to enable a relatively shallow ion-implanted region to be formed using a relatively high beam energy.

US patent No. 4771012 describes a method of fabricating a FET in which the source and drain are formed by ion implantation using the gate as a mask, the ion beam being tilted to an angle of 7° from a line perpendicular to the substrate surface to avoid channelling in the substrate. The substrate is rotated during implantation to eliminate any effects of shadowing of the substrate by the gate and to reduce any resulting asymmetry of the source and drain structures.

At Figure 6, US 4771012 describes the fabrication of a LDD MOSFET having two regions of different impurity concentrations in each of the source and drain. The first region in each is formed using the gate as a mask and the second using a subsequently formed side wall as a mask. Both regions are formed using a 7° tilted ion beam.

The invention provides a method of making a metal-oxide semiconductor field-effect transistor (MOSFET) as defined in claim 1, and a MOSFET structure made by the method of claim 1. A preferred feature of the invention is defined in a subclaim.

Advantageously, the invention may thus provide an improved method for making a metal-oxide semiconductor field-effect transistor whose structure permits reduction of its size without lowering its current driving capability.

Other objects and advantages of the present invention will be understood from the following description of preferred embodiments of the present invention and accompanying drawings.
Fig.1 schematically shows, in section, a MOSFET using a first known structure;
Fig.2 schematically shows, in section, a MOSFET using a second known structure;
Figs.3A to 3D show the manner in which a semi-fabricated MOSFET is prepared according to a conventional method; and
Figs.3E to 3J show a manner in which an improved MOSFET according to the present invention is made; and
Figs.4F to 4L show a known method of making the MOSFET of Fig.2.

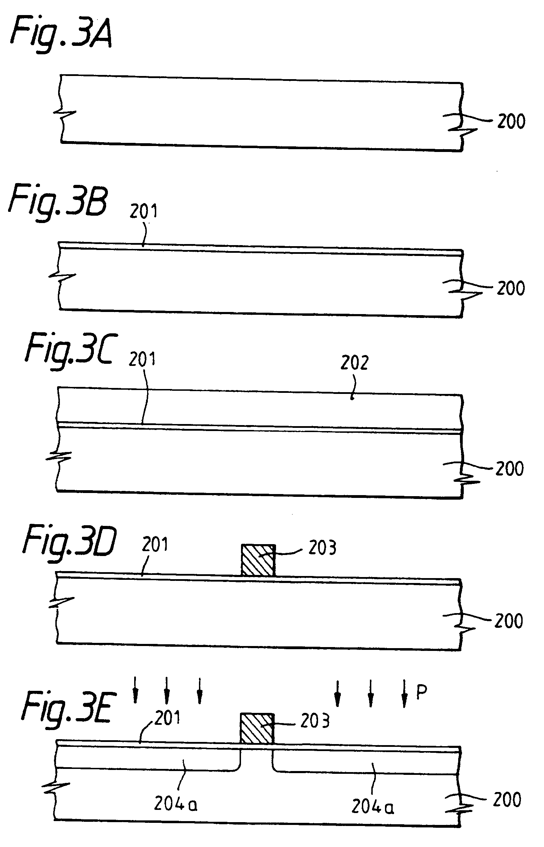

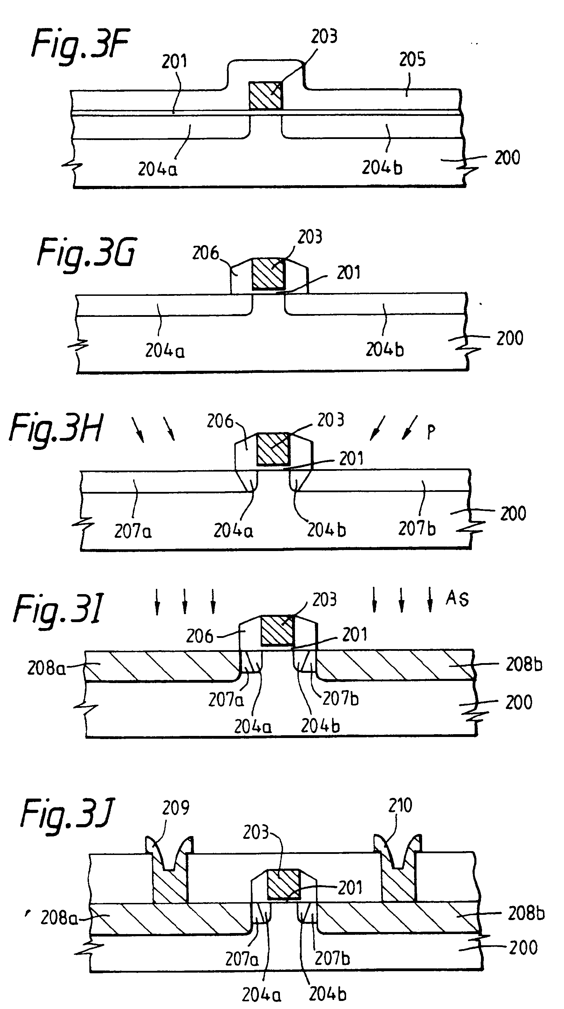

Referring to Figs.3A to 3J, a method of making a MOSFET according to the present invention is described. Figs.3A to 3D show how a semi-fabricated product comprising a semiconductor substrate of one conductivity type with a gate insulating layer formed on its top surface, and a gate built on the gate insulating layer can be prepared according to a conventional method. Specifically, a P-type silicon substrate 200 is prepared (Fig.3A); a silicon oxide layer 201 is formed on the top surface of the substrate 200 by heating the substrate 200 in an oxidizing atmosphere (Fig.3B); a polysilicon layer 202 is formed on the silicon oxide layer 201 (Fig.3C); and the polysilicon layer 202 is subjected to anisotropic etching to leave a gate 203 on the silicon oxide layer 201 (Fig.3D). Thus, a semi-fabricated product results.

Phosphorus ions (1 x 10¹³cm⁻²; 40 KeV) are then injected perpendicular to the top surface of the P-type substrate to form two opposite N-type diffusion layers 204a and 204b of least concentration of phosphorus in the substrate 200. These diffused regions 204a and 204b extend from first and second locations under one and the other edges of the gate 203 respectively in opposite directions (Fig.3E).

A 2000 angstrom-thick oxide layer 205 is formed on the semi-fabricated product (Fig.3F); and the thick oxide layer 205 is subjected to anisotropic etching until the top surface of the substrate 200 is exposed to leave a side wall 206 surrounding the gate 203 (Fig.3G).

Phosphorus ions (5 x 10¹³cm⁻²; 50 to 60 KeV) are injected to the P-type substrate 200 at 45 degrees to form two opposite N-type diffusion layers 207a and 207b of less, or an intermediate, concentration of phosphorus in the substrate 200 (Fig.3H). These diffused regions 207a and 207b extend short of the terminal ends of the diffusion layers 204a and 204b of least concentration of phosphorus.

Arsenic ions (5 x 10¹⁵cm⁻²; 70 KeV) are injected to the P-type substrate 200 perpendicular to the top surface of the substrate to form two opposite diffusion layers 208a and 208b of relatively high concentration of arsenic in the substrate 200 (Fig.3I). These heavily diffused regions 208a and 208b extend from first and second locations under one and the other edges of the side wall 206 in opposite directions.

Finally, a source electrode 209, a drain electrode 210 and a gate electrode (not shown) are formed respectively (Fig.3J).

It should be noted that the two diffused regions 208a and 208b are of the same construction. Conveniently this permits either diffused region to be used as drain when the device is actually used.

As is seen from Figure 3J, a metal-oxide semiconductor field-effect transistor thus made has two similar diffused regions each extending toward and ending at a location under one or the other edge of the gate 203 in the substrate 200. Each is composed of a first relatively short section 204a, 204b of least concentration of impurity, a second relatively short section 207a, 207b of less concentration of impurity, and a third relatively long section 208a, 208b of relatively high concentration of impurity. As described earlier, this permits either diffused region to be used as drain when actually the device is used.

## Claims

1. A method of making a metal-oxide semiconductor field-effect transistor by preparing a semi-fabricated product comprising a semiconductor substrate (200) of one conductivity type with a gate insulating layer (201) formed on its top surface, and a gate (203) built on said gate insulating layer, forming two diffused regions of the other conductivity type extending apart in opposite directions from under one and the other edges of said gate, and forming drain, source and gate electrodes, at least one of said diffused regions being formed by the following steps;
(A) injecting an impurity of the other conductivity type into said semiconductor substrate perpendicular to the top surface of said semiconductor substrate to form a diffusion layer (204a, 204b) of least concentration of impurity in said semiconductor substrate, extending from a location under one edge of said gate;
(B) forming a side wall (206) surrounding said gate on said semiconductor substrate; and
(C) injecting an impurity of the other conductivity type into said semiconductor substrate perpendicular to the top surface of said semiconductor substrate to form a diffusion layer (208a, 208b) of relatively high concentration of impurity in said semiconductor substrate, extending from a location under a corresponding edge of said side wall;
characterised by the step (D) of, after the side wall has been formed, injecting an impurity of the other conductivity type into said semiconductor substrate at a given acute angle with respect to the normal line perpendicular to the top surface of said semiconductor substrate to form a diffusion layer (207a, 207b) of less concentration of impurity in said semiconductor substrate, extending beneath the side wall, short of the end of said diffusion layer (204a, 204b) of least concentration of impurity.

2. A method according to Claim 1, in which both of the two diffused regions are formed according to similar steps, so that in step (A) two opposite diffusion layers (204a, 204b) of least concentration of impurity are formed, extending in opposite directions from first and second locations under the one and the other edges of the gate respectively, in step (C) two opposite diffusion layers (208a, 208b) of relatively high concentration of impurity are formed, extending in opposite directions from first and second locations under the one and the other corresponding edges of the side wall, and in step (D) two opposite diffusion layers (207a, 207b) of less concentration of impurity are formed, extending short of the ends of the diffusion layers (204a, 204b) of least concentration of impurity.

## Patentansprüche

1. Verfahren zur Herstellung eines Metall-Oxid-Halbleiter-Feldeffekttransistors durch Herstellen eines Halbfertigprodukts mit einem Halbleitersubstrat (200) eines Leitfähigkeitstyps, auf dessen oberer Fläche eine Gate-Isolierschicht (201) ausgebildet ist, und einem auf der Gate-Isolierschicht aufgebauten Gate (203), Ausbilden zweier diffundierter Bereiche des anderen Leitfähigkeitstyps, die sich von unterhalb des einen und des anderen Randes des Gates in entgegengesetzte Richtungen erstrecken, und Ausbilden von Drain-, Source- und Gate-Elektroden, wobei mindestens einer der diffundierten Bereiche durch die folgenden Schritte ausgebildet wird:
(A) Injektion von Störstellen des anderen Leitfähigkeitstyps in das Halbleitersubstrat senkrecht zur oberen Fläche des Halbleitersubstrats, um eine Diffusionsschicht (204a, 204b) mit geringster Störstellenkonzentration in dem Halbleitersubstrat auszubilden, die sich von einer Stelle unterhalb eines Randes des Gates aus erstreckt;
(B) Ausbilden einer Seitenwand (206), die das Gate auf dem Halbleitersubstrat umgibt; und
(C) Injektion von Störstellen des anderen Leitfähigkeitstyps in das Halbleitersubstrat senkrecht zur oberen Fläche des Halbleitersubstrats, um eine Diffusionsschicht (208a, 208b) von relativ hoher Störstellenkonzentration in dem Halbleitersubstrat auszubilden, die sich von einer Stelle unter einem entsprechenden Rand der Seitenwand aus erstreckt;
gekennzeichnet durch den Schritt (D), wobei nach dem Ausbilden der Seitenwand Störstellen des anderen Leitfähigkeitstyps unter einem vorgegebenen spitzen Winkel bezüglich der Flächennormalen zur oberen Fläche des Halbleitersubstrats in das Halbleitersubstrat injiziert werden, um eine Diffusionsschicht (207a, 207b) von geringerer Störstellenkonzentration in dem Halbleitersubstrat auszubilden, die von unterhalb der Seitenwand, kurz vor dem Ende der Diffusionsschicht (204a, 204b) mit geringster Störstellenkonzentration, ausgeht.

2. Verfahren nach Anspruch 1, wobei beide diffundierten Bereiche gemäß ähnlichen Verfahrensschritten ausgebildet werden, so daß im Schritt (A) zwei einander gegenüberliegende Diffusionsschichten (204a, 204b) von geringster Störstellenkonzentration ausgebildet werden, die sich von einer ersten und einer zweiten Stelle unter dem einen bzw. dem anderen Rand des Gates aus in entgegengesetzte Richtungen erstrecken, während im Schritt (C) zwei einander gegenüberliegende Diffusionsschichten (208a, 208b) von relativ hoher Störstellenkonzentration ausgebildet werden, die sich von einer ersten und einer zweiten Stelle unter dem einen bzw. dem anderen Rand der Seitenwand aus in entgegengesetzte Richtungen erstrecken, und im Schritt (D) zwei einander gegenüberliegende Diffusionsschichten (207a, 207b) von geringerer Störstellenkonzentration ausgebildet werden, die von Stellen kurz vor den Enden der Diffusionsschichten (204a, 204b) mit geringster Störstellenkonzentration ausgehen.

## Revendications

1. Procédé de fabrication d'un transistor à effet de champ en semi-conducteur métal-oxyde par préparation d'un produit semi-fini comprenant un substrat de semi-conducteur (200) d'un premier type de conductivité avec une couche d'isolation de grille (201) formée sur sa surface supérieure, et une grille (203) construite sur ladite couche d'isolation de grille, par formation de deux régions diffusées de l'autre type de conductivité s'étendant séparément dans des directions opposées à partir du dessous d'un et de l'autre bords de ladite grille, et par formation d'électrodes de drain, de source et de grille, au moins l'une desdites régions diffusées étant formée par les étapes suivantes consistant à :
(A) injecter une impureté de l'autre type de conductivité dans ledit substrat de semi-conducteur perpendiculairement à la surface supérieure dudit substrat de semi-conducteur pour former une couche de diffusion (204a, 204b) de concentration la plus basse en impureté dans ledit substrat de semi-conducteur, s'étendant à partir d'un emplacement situé au-dessous d'un bord de ladite grille;
(B) former une paroi latérale (206) entourant ladite grille sur ledit substrat de semi-conducteur; et
(C) injecter une impureté de l'autre type de conductivité dans ledit substrat de semi-conducteur perpendiculairement à la surface supérieure dudit substrat de semi-conducteur pour former une couche de diffusion (208a, 208b) d'une concentration en impureté relativement élevée dans ledit substrat de semi-conducteur, s'étendant à partir d'un emplacement se trouvant au-dessous d'un bord correspondant de ladite paroi latérale;
caractérisé par une étape (D), après la formation de la paroi latérale, consistant à injecter une impureté de l'autre type de conductivité dans ledit substrat de semi-conducteur à un angle aigu donné par rapport à la ligne perpendiculaire à la surface supérieure dudit substrat de semi-conducteur pour former une couche de diffusion (207a, 207b) d'une concentration plus basse en impureté dans ledit substrat de semi-conducteur, s'étendant au-dessous de la paroi latérale, en deçà de l'extrémité de ladite couche de diffusion (204a, 204b) de concentration la plus basse en impureté.

2. Procédé selon la revendication 1, dans lequel les deux couches diffusées sont formées conformément à des étapes similaires, de sorte que dans l'étape (A) deux couches de diffusion opposées (204a, 204b) de concentration la plus basse en impureté sont formées, s'étendant dans des directions opposées à partir de premier et second emplacements au-dessous de l'un et de l'autre bords de la grille, respectivement; dans l'étape (C) deux couches de diffusion opposées (208a, 208b) d'une concentration relativement élevée en impureté sont formées, s'étendant dans des directions opposées à partir de premier et second emplacements au-dessous de l'un et de l'autre bords correspondants de la paroi latérale, et dans l'étape (D) deux couches de diffusion opposées (207a, 207b) de concentration plus basse en impureté sont formées, s'étendant en deçà des extrémités des couches de diffusion (204a, 204b) de concentration la plus basse en impureté.
